# EUROPEAN PATENT APPLICATION

(11) **EP 4 818 709 A1**
(43) Date of publication of application: **07.10.2026**
(21) Application number: 24895972.8
(22) Date of filing: 27.09.2024
(51) Int. Cl.: G01R 27/08, G01R 31/36

(54) **BATTERY MODULE DETECTION SYSTEM AND METHOD**

(30) Priority: 30.11.2023 CN 202311641695
(71) Applicant: BYD Company Limited, Shenzhen, Guangdong 518118 (CN)
(72) Inventor: CHEN, Mailin, Shenzhen, Guangdong 518118 (CN); WANG, Peng, Shenzhen, Guangdong 518118 (CN); LI, Zhiqiang, Shenzhen, Guangdong 518118 (CN); WANG, Sanlin, Shenzhen, Guangdong 518118 (CN); WANG, Chengzhi, Shenzhen, Guangdong 518118 (CN)
(74) Representative: Mathys & Squire
(86) International application number: PCT/CN2024/121611
(87) International publication number: WO 2025/112876

(57) **Abstract**

A battery module detection system and method. The battery module detection system comprises a control circuit and a detection circuit, wherein the detection circuit comprises a resistance unit. The control circuit is configured to: control transmission of a power supply voltage to the detection circuit and obtain a detection voltage fed back by the detection circuit, determine detection parameters inside a battery module on the basis of the power supply voltage, the detection voltage and the resistance value of the resistance unit, and on the basis of the detection parameters inside the battery module, determine whether an insulation abnormality is present inside the battery module.

## Description

### CROSS-REFERENCE TO RELATED APPLICATIONS

This application claims the priority of the Chinese patent application with application number 202311641695.7, entitled "BATTERY MODULE DETECTION SYSTEM AND METHOD", filed with the China Patent Office on November 30, 2023, the entire contents of which are incorporated herein by reference.

### FIELD

The present application relates to the field of power electronics technology, and in particular, to a battery module detection system and a method.

### BACKGROUND

A power battery pack is composed of one or more battery modules, and each battery module includes a plurality of cells. Generally, the housing of the power battery pack is insulated from the battery modules inside the power battery pack, and the housing of each battery module is insulated from the plurality of cells inside the battery module.

However, due to factors such as environment and long-term operation, the cells inside the battery module are prone to insulation abnormalities such as liquid leakage, arcing or micro-short circuits. When the insulation resistance between the housing of the battery module and the internal cells decreases, the insulation performance between the housing of the battery module and the internal cells deteriorates, which may bring safety hazards to the power battery pack and even related vehicles.

### SUMMARY

In a first aspect, the present application provides a battery module detection system, the system includes a control circuit and a detection circuit, the detection circuit is electrically connected to a housing of a battery module, the detection circuit includes a resistance unit, the control circuit is connected to the detection circuit, and the control circuit is configured to: control transmission of a power supply voltage to the detection circuit, and obtain a detection voltage fed back by the detection circuit; determine a detection parameter inside the battery module on the basis of the power supply voltage, the detection voltage and a resistance value of the resistance unit, and on the basis of the detection parameter inside the battery module, determine whether an insulation abnormality is present inside the battery module.

In a possible embodiment, the power supply voltage includes a first power supply voltage, and the detection voltage includes a first detection voltage fed back by the detection circuit; the detection parameter inside the battery module includes an insulation resistance of the battery module; and
the control circuit is configured to determine the insulation resistance of the battery module on the basis of the first power supply voltage, the first detection voltage and the resistance value of the resistance unit, and on the basis of the insulation resistance of the battery module and a preset resistance threshold, determine whether an insulation abnormality is present between a plurality of cells inside the battery module and the housing of the battery module.

In a possible embodiment, the power supply voltage includes a first power supply voltage and a second power supply voltage, and the detection voltage includes a first detection voltage and a second detection voltage, the first detection voltage is a detection voltage fed back by the detection circuit when the power supply voltage is the first power supply voltage; the second detection voltage is a detection voltage fed back by the detection circuit when the power supply voltage is the second power supply voltage; the detection parameter inside the battery module includes an insulation resistance of the battery module; and
the control circuit is configured to determine the insulation resistance of the battery module on the basis of the first power supply voltage, the second power supply voltage, the first detection voltage, the second detection voltage, and the resistance value of the resistance unit, and on the basis of the insulation resistance of the battery module and a preset resistance threshold, determine whether an insulation abnormality is present between a plurality of cells inside the battery module and the housing of the battery module.

In a possible embodiment, the detection parameter inside the battery module further includes an insulation voltage of the battery module; and
the control circuit is configured to determine the insulation voltage of the battery module on the basis of the first power supply voltage, the second power supply voltage, the first detection voltage, the second detection voltage, and the resistance value of the resistance unit, and when the insulation resistance is less than the preset resistance threshold, determine a cell having an insulation abnormality from among the plurality of cells inside the battery module on the basis of the insulation voltage of the battery module.

In a possible embodiment, the control circuit is configured to, when the insulation resistance is less than the preset resistance threshold, determine a cell corresponding to an obtained target voltage threshold interval inside the battery module as the cell having the insulation abnormality.

In a possible embodiment, the resistance unit includes a first resistor, a second resistor, a third resistor, a fourth resistor, and a fifth resistor; wherein one end of the first resistor is connected to a first port of the control circuit, the other end of the first resistor is connected respectively to one end of the second resistor, one end of the third resistor, and one end of the fourth resistor, the other end of the second resistor is connected to a second port of the control circuit, the other end of the third resistor, the other end of the fourth resistor, and one end of the fifth resistor are all grounded, and the other end of the fifth resistor is connected to the housing of the battery module; and
the control circuit is configured to transmit the power supply voltage through the first port and obtain the detection voltage through the second port.

In a possible embodiment, the power supply voltage includes a first power supply voltage, and the detection voltage includes a first detection voltage fed back by the detection circuit; the control circuit being configured to determine the insulation resistance inside the battery module on the basis of the first power supply voltage, the first detection voltage, and the resistance value of the resistance unit, includes:
the control circuit being configured to calculate the insulation resistance of the battery module according to the following formula:
   $R = \frac{{U}_{1} ∗ {V}_{1} ∗ \left({R}_{2}+{R}_{3}+{R}_{4}\right) ∗ \left({R}_{2}+{R}_{3}\right)}{\left({R}_{3}+{R}_{4}\right) ∗ \left({R}_{2}+{R}_{4}\right) + \left({R}_{2}+{R}_{3}+{R}_{4}\right) ∗ 2 {R}_{3} ∗ {U}_{1} ∗ 2 {R}_{2} + \left({R}_{2}+{R}_{4}\right) + \left({R}_{2}+{R}_{3}+{R}_{4}\right) ∗ 2 {R}_{3}}$
wherein, R is a resistance value of the insulation resistance, *U*₁ is the first detection voltage, *V*₁ is the first power supply voltage, *R*₁ is a resistance value of the first resistor, *R*₂ is a resistance value of the second resistor, *R*₃ is a resistance value of the third resistor, *R*₄ is a resistance value of the fourth resistor, and *R*₅ is a resistance value of the fifth resistor.

In a possible embodiment, the power supply voltage includes a first power supply voltage and a second power supply voltage, and the detection voltage includes a first detection voltage and a second detection voltage; the control circuit being configured to determine the insulation resistance of the battery module on the basis of the first power supply voltage, the second power supply voltage, the first detection voltage, the second detection voltage, and the resistance value of the resistance unit, includes:
the control circuit being configured to calculate the insulation resistance of the battery module according to the following formula:
   $\begin{matrix}R = \frac{{R}_{3} ∗ {V}_{1} + {R}_{4} ∗ {V}_{1} - {R}_{3} ∗ {V}_{2} + {R}_{3} ∗ {V}_{1} - {R}_{4} ∗ {V}_{2} - {R}_{5} ∗ {V}_{2} + {R}_{2} ∗ {R}_{3} ∗ {U}_{1} - {R}_{2} ∗ {R}_{3} ∗ {U}_{2} + {R}_{2} ∗ {R}_{4} ∗ {U}_{1}}{{V}_{1} - {V}_{2} + {R}_{2} ∗ {U}_{1} - {R}_{2} ∗ {U}_{2} + {R}_{3} ∗ {U}_{1} - {R}_{3} ∗ {U}_{2}} \\ - \frac{{R}_{2} ∗ {R}_{4} ∗ {U}_{2} + {R}_{2} ∗ {R}_{5} ∗ {U}_{1} + {R}_{3} ∗ {R}_{4} ∗ {U}_{1} - {R}_{2} ∗ {R}_{5} ∗ {U}_{2} - {R}_{3} ∗ {R}_{4} ∗ {U}_{2} - {R}_{3} ∗ {R}_{5} ∗ {U}_{1} - {R}_{3} ∗ {R}_{5} ∗ {U}_{2}}{{V}_{1} - {V}_{2} + {R}_{2} ∗ {U}_{1} - {R}_{2} ∗ {U}_{2} + {R}_{3} ∗ {U}_{1} - {R}_{3} ∗ {U}_{2}}\end{matrix}$
wherein, R is a resistance value of the insulation resistance, *U*₁ is the first detection voltage, *U*₂ is the second detection voltage, *V*₁ is the first power supply voltage, *V*₂ is the second power supply voltage, *R*₁ is a resistance value of the first resistor, *R*₂ is a resistance value of the second resistor, *R*₃ is a resistance value of the third resistor, *R*₄ is a resistance value of the fourth resistor, and *R*₅ is a resistance value of the fifth resistor.

In a possible embodiment, the power supply voltage includes a first power supply voltage and a second power supply voltage, and the detection voltage includes a first detection voltage and a second detection voltage; the control circuit is configured to calculate the insulation voltage of the battery module according to the following formula:
${U}_{x} = \frac{{R}_{3} ∗ {U}_{1} ∗ {V}_{1} + {R}_{4} ∗ {U}_{1} ∗ {V}_{1} + {R}_{5} ∗ {U}_{1} ∗ {V}_{1} - {R}_{3} ∗ {U}_{2} ∗ {V}_{2} - {R}_{4} ∗ {U}_{2} ∗ {V}_{2} - {R}_{5} ∗ {U}_{2} ∗ {V}_{2}}{{R}_{3} ∗ {U}_{1} - {R}_{2} ∗ {U}_{2}}$
wherein, *Uₓ* is the insulation voltage, *U*₁ is the first detection voltage, *U*₂ is the second detection voltage, *V*₁ is the first power supply voltage, *V*₂ is the second power supply voltage, *R*₁ is a resistance value of the first resistor, *R*₂ is a resistance value of the second resistor, *R*₃ is a resistance value of the third resistor, *R*₄ is a resistance value of the fourth resistor, and *R*₅ is a resistance value of the fifth resistor.

In a possible embodiment, the detection circuit further includes a first capacitor and a second capacitor; wherein the first capacitor is connected in parallel with the third resistor, one end of the second capacitor is connected to the other end of the fourth resistor, and the other end of the second capacitor is grounded.

In a possible embodiment, the detection circuit further includes a first diode and a second diode; wherein an anode of the first diode is connected to the first port of the control circuit, a cathode of the first diode is connected to one end of the second resistor; a cathode of the second diode is connected to the second port of the control circuit, and an anode of the second diode is grounded.

In a second aspect, the present application further provides a battery module detection method, wherein the method is performed by a battery module detection system, the battery module detection system includes a control circuit and a detection circuit connected to the control circuit, the detection circuit is electrically connected to a housing of a battery module and includes a resistance unit, the method including:
a power supply voltage being controlled to be transmitted to the detection circuit by the control circuit, and a detection voltage fed back by the detection circuit being obtained;
a detection parameter inside the battery module being determined by the control circuit on the basis of the power supply voltage, the detection voltage, and the resistance value of the resistance unit, and on the basis of the detection parameter inside the battery module, whether an insulation abnormality is present inside the battery module being determined.

In a possible embodiment, the power supply voltage includes a first power supply voltage, and the detection voltage includes a first detection voltage fed back by the detection circuit; wherein the detection parameter inside the battery module includes an insulation resistance of the battery module;
the detection parameter inside the battery module is determined on the basis of the power supply voltage, the detection voltage, and the resistance value of the resistance unit, and on the basis of the detection parameter inside the battery module, whether the insulation abnormality is present inside the battery module is determined, including:
the insulation resistance of the battery module being determined on the basis of the first power supply voltage, the first detection voltage, and the resistance value of the resistance unit, and on the basis of the insulation resistance of the battery module and a preset resistance threshold, whether an insulation abnormality is present between a plurality of cells inside the battery module and the housing of the battery module being determined.

In a possible embodiment, the power supply voltage includes a first power supply voltage and a second power supply voltage, and the detection voltage includes a first detection voltage and a second detection voltage, wherein the first detection voltage is a detection voltage fed back by the detection circuit when the power supply voltage is the first power supply voltage; the second detection voltage is a detection voltage fed back by the detection circuit when the power supply voltage is the second power supply voltage; the detection parameter inside the battery module includes an insulation resistance of the battery module; and
the detection parameter inside the battery module is determined on the basis of the power supply voltage, the detection voltage, and the resistance value of the resistance unit, and on the basis of the detection parameter inside the battery module, whether the insulation abnormality is present inside the battery module is determined, including:
the insulation resistance of the battery module being determined on the basis of the first power supply voltage, the second power supply voltage, the first detection voltage, the second detection voltage, and the resistance value of the resistance unit, and on the basis of the insulation resistance of the battery module and a preset resistance threshold, whether an insulation abnormality is present between a plurality of cells inside the battery module and the housing of the battery module being determined.

In a possible embodiment, the power supply voltage includes a first power supply voltage and a second power supply voltage, the detection voltage includes a first detection voltage and a second detection voltage, and the detection parameter inside the battery module further includes an insulation voltage of the battery module;
the detection parameter inside the battery module is determined on the basis of the power supply voltage, the detection voltage, and the resistance value of the resistance unit, and on the basis of the detection parameter inside the battery module, whether the insulation abnormality is present inside the battery module is determined, including:
the control circuit is configured to determine the insulation voltage of the battery module on the basis of the first power supply voltage, the second power supply voltage, the first detection voltage, the second detection voltage, and the resistance value of the resistance unit, and when the insulation resistance is less than the preset resistance threshold, determine a cell having an insulation abnormality from among the plurality of cells inside the battery module on the basis of the insulation voltage of the battery module.

In a possible embodiment, when the insulation resistance is less than the preset resistance threshold, a cell having an insulation abnormality is determined from among the plurality of cells inside the battery module on the basis of the insulation voltage of the battery module, including:
when the insulation resistance is less than the preset resistance threshold, a cell corresponding to an obtained target voltage threshold interval inside the battery module is determined as the cell having the insulation abnormality.

In a third aspect, the present application further provides a non-volatile computer-readable storage medium, wherein a computer program or computer instructions are stored in the non-volatile computer-readable storage medium, the computer program or computer instructions being executed by a processor to implement the method according to any one of the second aspects above.

In a fourth aspect, the present application further provides a computer program product, wherein when the computer program product is executed by a processor, the method according to any one of the second aspects above is performed.

In a fifth aspect, the present application further provides a battery information collector, the battery information collector including the battery module detection system according to the first aspect.

In a sixth aspect, the present application further provides a power supply device, including a battery module, a battery management system, and the battery module detection system according to the first aspect or the battery information collector according to the fifth aspect; wherein the battery module detection system is configured to detect an insulation abnormality inside the battery module, generate a detection result on the basis of the insulation abnormality inside the battery module, and send the detection result to the battery management system; wherein the battery management system is configured to output an abnormality prompt or a normal prompt on the basis of the detection result.

In a possible embodiment, the battery module includes at least two cells connected in series.

In a seventh aspect, the present application further provides an electric device, the electric device including the power supply device according to the sixth aspect.

### BRIEF DESCRIPTION OF THE DRAWINGS

To describe the technical solutions in the embodiments of the present application more clearly, the following briefly introduces the accompanying drawings required for describing the embodiments. Apparently, the accompanying drawings in the following description show merely some embodiments of the present application, and a person of ordinary skill in the art may still derive other drawings from these accompanying drawings without creative labor.
FIG. 1 is a schematic structural diagram of a power battery pack provided in an embodiment of the present application;
FIG. 2 is another schematic structural diagram of the power battery pack provided in an embodiment of the present application;
FIG. 3 is a schematic structural diagram of a battery module detection system provided in an embodiment of the present application;
FIG. 4 is a schematic structural diagram of a detection circuit provided in an embodiment of the present application;
FIG. 5 is another schematic structural diagram of the detection circuit provided in an embodiment of the present application;
FIG. 6 is a schematic flowchart of a battery module detection method provided in the present application;
FIG. 7 is a schematic structural diagram of a power supply device provided in an embodiment of the present application;
FIG. 8 is a schematic structural diagram of a battery information collector provided in an embodiment of the present application;
FIG. 9 is a schematic structural diagram of an electric device provided in an embodiment of the present application.

Description of reference numerals:
300 - battery module detection system, 301 - control circuit, 302 - detection circuit, 320 - battery module, 330 - housing, 310 - power battery pack, (C1) - first capacitor, (C2) - second capacitor, (D1) - first diode, (D2) - second diode.

### DETAILED DESCRIPTION

The technical solutions in the embodiments of the present application are described clearly and completely in the following with reference to the accompanying drawings in the embodiments of the present application. Apparently, the described embodiments are merely some embodiments of the present application, rather than all embodiments. All other embodiments obtained by a person of ordinary skill in the art based on the embodiments of the present application without creative labor shall fall within the protection scope of the present application.

Detailed descriptions are respectively provided below.

In the specification, claims, and the accompanying drawings of the present application, the terms "first", "second", "third", "fourth", and the like are used to distinguish different objects, rather than to describe a specific order. In addition, the terms "include" and "have", as well as any variations thereof, are intended to cover non-exclusive inclusion. For example, a process, method, system, product, or device that includes a series of steps or units is not necessarily limited to those steps or units explicitly listed, but may optionally include other steps or units not explicitly listed, or may optionally include other steps or units inherent to such process, method, product, or device.

Reference to an "embodiment" herein means that a particular feature, structure, or characteristic described in connection with the embodiment may be included in at least one embodiment of the present application. The appearances of this phrase in various places in the specification are not necessarily all referring to the same embodiment, nor are they separate or alternative embodiments mutually exclusive with other embodiments. It is understood, both explicitly and implicitly, by a person skilled in the art that the embodiments described herein may be combined with other embodiments.

It will be noted that a power battery pack is a power source for new energy vehicles, configured to store electrical energy and provide the electrical energy to the new energy vehicle. Typically, the output voltage of a power battery pack exceeds 300 volts. Therefore, a plurality of cells may be connected in series or in parallel to form a battery module, and then a plurality of battery modules may be connected in series or in parallel to form a power battery pack, so as to increase the output voltage of the power battery pack.

Exemplarily, the battery module may be a battery module composed of a plurality of cells. Alternatively, the battery module may also be a battery pack formed by packaging a plurality of cells. Alternatively, the battery module may also be formed by directly encapsulating a plurality of cells in a chassis. It will be understood that this is merely an example and does not constitute a limitation on the embodiments of the present application.

The present application provides a battery module detection system and a method. An insulation abnormality inside a battery module can be detected, ensuring the safety and stability of the battery module.

In an embodiment of the present application, the battery module detection system can detect an insulation abnormality inside a battery module, can locate the battery module having the insulation abnormality, and facilitates timely warning when an insulation abnormality occurs inside the battery module, thereby ensuring the safety and effectiveness of the battery module, the power battery pack, and the vehicle. Herein, the battery module detection system includes a control circuit and a detection circuit. The detection circuit is respectively connected to the control circuit and the battery module to be detected. Further, the control circuit can generate and transmit a power supply voltage to the detection circuit. The detection circuit includes a resistance unit. The detection circuit generates a detection voltage based on the resistance unit, the power supply voltage, and the battery module; the detection circuit can feed the generated detection voltage back to the control circuit. A detection parameter inside the battery module is calculated by the control circuit on the basis of the received detection voltage, the generated power supply voltage, and the resistance value of the resistance unit. It will be understood that this detection parameter will be understood as a parameter used to characterize an insulation abnormality between a plurality of cells inside the battery module and the housing of the battery module. Therefore, the insulation abnormality inside the battery module can be determined by the control circuit on the basis of the detection parameter, which facilitates timely warning when an insulation abnormality occurs inside the battery module, thereby facilitating maintenance personnel to troubleshoot the abnormality of the battery module, ensuring the safety and effectiveness of the battery module, the power battery pack, and the vehicle.

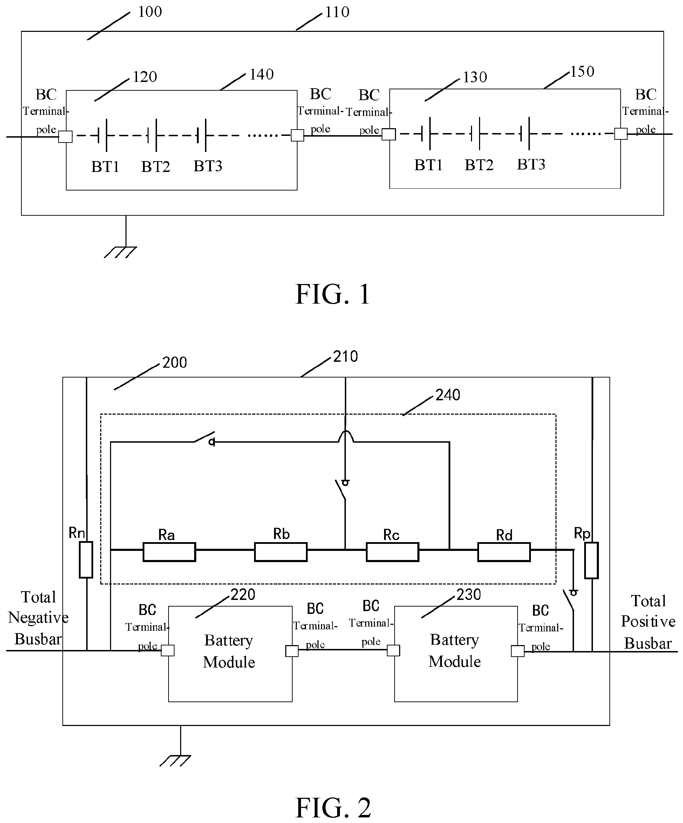

In some feasible embodiments, reference is made to FIG. 1. FIG. 1 is a schematic structural diagram of a power battery pack provided in an embodiment of the present application. As shown in FIG. 1, the power battery pack 100 includes a housing 110 and a plurality of battery modules. The housing 110, as a protective structure of the power battery pack 100, can fix and support the plurality of battery modules therein. The plurality of battery modules include a battery module 120 and a battery module 130. The plurality of battery modules are connected in series through BC terminal-poles. The BC terminal-poles will be understood as connection terminals of the battery module for connecting to external conductors. For example, the BC terminal-pole of the battery module 130 is connected to the BC terminal-pole of the battery module 120, thereby electrically connecting the battery module 130 and the battery module 120. Further, in FIG. 1, each battery module includes a housing and a plurality of cells BT1, BT2, BT3, . . . , the plurality of cells being connected in series. The housing of the battery module is configured to encapsulate and protect the plurality of cells inside the battery module, thereby preventing short circuits between different battery modules from affecting the normal operation of the power battery pack 100. It will be understood that the voltage of each of the battery modules is equal to the sum of the voltages of the plurality of cells connected in series inside the battery module. Similarly, the voltage of the power battery pack 100 is equal to the sum of the voltages of the plurality of battery modules connected in series inside the power battery pack 100.

In some feasible embodiments, the housing 110 of the power battery pack 100 is insulated from the plurality of battery modules, which can prevent external interference with the plurality of battery modules inside the power battery pack 100. For example, in humid, high-temperature, or other external environments, the housing 110, being insulated from the plurality of battery modules, can ensure that the plurality of battery modules remain safe and effective. Similarly, the housing of each of the battery modules is insulated from the plurality of cells inside the battery module, which can prevent adverse effects on the internal plurality of cells from the outside, while also preventing mutual interference between different battery modules. For example, assuming a cell of the battery module 120 in FIG. 1 malfunctions, because the battery module 120 is insulated from the battery module 130 by its housing 140, and the battery module 130 is insulated from the battery module 120 by its housing 150, the malfunction of the battery module 120 does not affect the normal operation of the battery module 130.

It will be noted that when an insulation abnormality occurs in a battery module or a cell inside a power battery pack, the insulation performance between the housing of the power battery pack and the battery module is degraded, thereby affecting the safety and stability of the power battery pack. Herein, the insulation performance between the housing of the power battery pack and the battery module will be understood as the resistance value of the equivalent insulation resistance between the housing of the power battery pack and the battery module. Further, the equivalent insulation resistance between the housing of the power battery pack and the battery module refers to the ratio of the voltage applied between the housing of the power battery pack and the battery module to the current flowing from the housing to the battery module or from the battery module to the housing. When the housing and the battery module are perfectly insulated, the resistance value of the equivalent insulation resistance is infinite. When the insulation performance between the battery and the battery module is degraded, the resistance value of the equivalent insulation resistance decreases; that is, the smaller the resistance value of the equivalent insulation resistance, the worse the insulation performance.

Similarly, the insulation performance between the housing of the battery module and the internal cells can also be characterized by the equivalent insulation resistance between the housing of the battery module and the internal cells.

In some feasible embodiments, when one or more cells of a battery module leak, and the liquid penetrates to the outside of the battery module, the leaked liquid can cause the housing of the power battery pack and the battery module to no longer be insulated, i.e., the insulation performance is degraded. To ensure the safety and stability of the power battery pack, the equivalent insulation resistance between the housing of the power battery pack and the battery module can be detected.

In some feasible embodiments, the equivalent insulation resistance between the housing of the power battery pack and the plurality of battery modules can be characterized by the resistance value between the busbar of the power battery pack and the housing. Herein, the busbar of the power battery pack will be understood as the bus for the power battery pack to supply power or charge. For ease of understanding, an example is described in an embodiment of the present application with reference to the power battery pack 200 in FIG. 2.

Reference is made to FIG. 2. FIG. 2 is another schematic structural diagram of the power battery pack provided in an embodiment of the present application. As shown in FIG. 2, the total negative busbar of the power battery pack 200 is connected to the BC terminal-pole of the battery module 220, which is equivalent to the negative electrode of the power battery pack 200; the total positive busbar of the power battery pack 200 is connected to the BC terminal-pole of the battery module 230, which is equivalent to the positive electrode of the power battery pack 200. In addition, the power battery pack 200 further includes a resistor Ra, a resistor Rb, a resistor Rc, and a resistor Rd connected in series. The equivalent insulation resistance between the housing 210 of the power battery pack 200 and the plurality of battery modules can be characterized by a resistor Rp between the total positive busbar of the power battery pack 200 and the housing 210, and a resistor Rn between the total negative busbar and the housing 210. To this end, the power battery pack 200 can detect the resistors Rp and Rn through an insulation detection circuit 240 to determine the equivalent insulation resistance between the housing 210 and the battery module 220 or the battery module 230, thereby enabling timely warning when an insulation abnormality occurs in one or more battery modules within the power battery pack 200.

However, as packaging technology for battery modules continues to upgrade and iterate, when a cell inside a battery module malfunctions, it usually does not affect the exterior of the battery module. For example, when a cell inside a battery module leaks, the leaked liquid typically remains inside the battery module, causing a degradation of the insulation performance inside the battery module, but does not penetrate to the outside of the battery module, thus not affecting the insulation performance between the power battery pack housing and the battery module. It will be understood that the insulation detection circuit 240 shown in FIG. 2 can only be used to detect the equivalent insulation resistance between the housing 210 of the power battery pack 200 and the plurality of battery modules, but cannot detect the insulation performance inside any single battery module. Consequently, when an abnormality occurs in a cell inside the battery, leading to a degradation of the insulation performance inside the battery module, a timely warning cannot be issued, posing a safety hazard.

Based on the above-mentioned technical problem, an embodiment of the present application provides a battery module detection system. The insulation performance inside a battery module can be detected, so that when an insulation abnormality occurs in a cell of the battery module, causing a decrease in the equivalent insulation resistance between the housing of the battery module and the cell, a timely warning can be issued, thereby improving the safety and stability of the power battery pack.

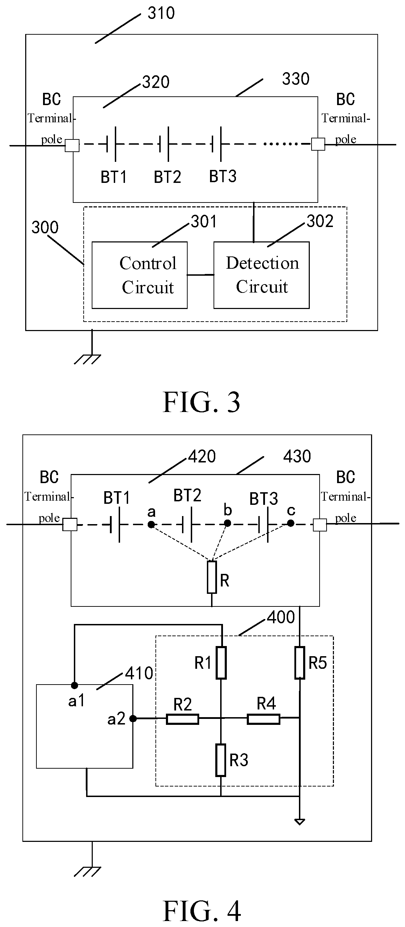

In some feasible embodiments, reference is made to FIG. 3. FIG. 3 is a schematic structural diagram of a battery module detection system provided in an embodiment of the present application. The battery module detection system 300 shown in FIG. 3 is disposed in a power battery pack 310 and is configured to detect an insulation abnormality inside a battery module 320 in the power battery pack 310. The battery module 320 internally includes a plurality of cells such as cell BT1, cell BT2, cell BT3, . . . . Further, an insulation abnormality inside the battery module 320 will be understood as a situation where the battery module 320 fails to operate normally due to an abnormality occurring in one or more cells among the plurality of cells inside the battery module 320. For example, when a leakage occurs in the cell BT1, the equivalent insulation resistance between the cell BT1 and the housing 330 of the battery module 320 decreases, i.e., an abnormality occurs in the cell BT1. Alternatively, when an arcing occurs in the cell BT2, the equivalent insulation resistance between the cell BT2 and the housing 330 also decreases, i.e., an abnormality occurs in the cell BT2. Alternatively, when a micro-short circuit occurs in the cell BT3, the equivalent insulation resistance between the cell BT3 and the housing 330 also decreases, i.e., an abnormality occurs in the cell BT3. An abnormality occurring in any cell in the battery module 320 may cause the battery module 320 to fail to operate normally, i.e., an insulation abnormality occurs inside the battery module 320. It will be noted that the insulation abnormalities such as the above-mentioned cell leakage, arcing, and micro-short circuit are only examples, and other insulation abnormalities may also occur in the battery module 320, which are not exhaustively described herein.

In some feasible embodiments, the battery module detection system 300 in the embodiment of the present application can obtain a detection parameter inside the battery module 320 by performing detection on the battery module 320. The detection parameter inside the battery module 320 will be understood as a parameter used to characterize whether there is an abnormality in the operation of a cell inside the battery module 320. Then, on the basis of the detection parameter, the battery module detection system 300 can determine whether there is an abnormality in the operation of a cell inside the battery module 320, thereby determining the insulation abnormality inside the battery module 320.

That is, the battery module detection system 300 may first obtain the detection parameter inside the battery module 320, and then determine the insulation abnormality inside the battery module 320 on the basis of the detection parameter. For ease of understanding, the specific process of obtaining the detection parameter inside the battery module 320 is explained in the following content of the embodiments of the present application.

It will be noted that when an insulation abnormality occurs inside the battery module 320, the voltage inside the battery module 320 also changes. For example, under normal conditions, the plurality of cells of the battery module 320 are insulated from the housing 330, so the voltage inside the battery module 320 is distributed among the plurality of cells connected in series, while the housing 330 is not electrically charged, i.e., the voltage of the housing 330 is 0. When a leakage occurs in the cell BT1 of the battery module 320, the cell BT1 is electrically connected to the housing 330 through the leaked liquid, so the voltage inside the battery module 320 is distributed between the housing 330 and the plurality of cells connected in series. At this time, the housing 330 is electrically charged, and the voltage of the housing 330 is no longer 0. That is, the voltage inside the battery module 320 can be used to characterize the insulation abnormality inside the battery module 320. Therefore, the battery module detection system 300 in the embodiment of the present application can detect the voltage change inside the battery module 320, so as to use the voltage change inside the battery module 320 as the detection parameter.

In some feasible embodiments, the battery module detection system 300 includes a control circuit 301 and a detection circuit 302. The detection circuit 302 is respectively connected to the battery module 320 and the control circuit 301. From the above description, when the voltage distribution inside the battery module 320 changes, the voltage of the housing 330 of the battery module 320 also changes, i.e., the voltage change of the housing 330 can reflect the voltage change inside the battery module 320. Therefore, the battery module detection system 300 can connect the detection circuit 302 to the housing 330 of the battery module 320, so that when an insulation abnormality occurs inside the battery module 320, causing a change in the voltage of the housing 330, a detection parameter is obtained, and then the insulation abnormality inside the battery module 320 is determined on the basis of the detection parameter.

In some feasible embodiments, while detecting the internal voltage of the battery module 320, the detection circuit 302 can also receive the power supply voltage generated by the control circuit 301. Further, when the internal voltage of the battery module 320 changes, causing the voltage of the housing 330 to also change, the detection circuit 302 can generate a corresponding detection voltage under the action of the voltage of the housing 330 and the power supply voltage. It will be noted that the detection circuit 302 includes a resistance unit, which can generate different detection voltages under different voltages of the housing 330 and different power supply voltages. Therefore, the detection circuit 302 can feed this detection voltage back to the control circuit 301, so that the control circuit 301 can, on the basis of the generated power supply voltage, the received detection voltage, and the resistance value of the resistance unit in the detection circuit 302, back-calculate the internal voltage of the battery module 320, and thereby determine the insulation abnormality inside the battery module 320.

In some feasible embodiments, the control circuit 301 can receive a power supply signal and operate based on the power supply signal. This power supply signal will be understood as the DC operating voltage of the control circuit 301. For example, assuming that the DC operating voltage of the control circuit 301 is 3.3 volts, the control circuit 301 can receive a 3.3-volt DC voltage as the power supply signal. It will be understood that this power supply signal may be provided to the control circuit 301 by an external DC power source, which is not limited in the present application. Further, the control circuit 301 can generate a power supply voltage on the basis of this power supply signal. Specifically, the control circuit 301 can amplify the power supply signal according to a preset amplification factor, thereby generating the power supply voltage. The amplification factor may be an integer or fraction greater than 0. For example, when the power supply signal of the control circuit 301 is 3.3 volts, and when the power supply voltage is also 3.3 volts, the control circuit 301 may preset the amplification factor to 1, and then amplify the power supply signal according to this amplification factor to generate a 3.3-volt power supply voltage. Similarly, when the power supply voltage is another value, the preset amplification factor may be changed to generate a corresponding power supply voltage. The power supply voltage is transmitted to the detection circuit 302, so that the detection circuit 302 generates a corresponding detection voltage under the action of this power supply voltage and the voltage of the housing 330, and feeds it back to the control circuit 301.

In some feasible embodiments, from the above description, the insulation performance between the housing 330 of the battery module 320 and the plurality of internal cells can be characterized by an insulation resistance inside the battery module 320. Herein, the insulation resistance inside the battery module 320 will be understood as the equivalent resistance between the plurality of internal cells and the housing 330 inside the battery module 320. For example, when there is no cell operating abnormally in the battery module 320, the plurality of cells in the battery module 320 are insulated from the housing 330, and the equivalent resistance between the plurality of cells and the housing 330 is infinite, i.e., the insulation resistance inside the battery module 320 is infinite. When the cell BT1 in the battery module 320 operates abnormally, the equivalent resistance between the cell BT1 and the housing 330 decreases, so the insulation resistance inside the battery module 320 decreases. Therefore, in the embodiment of the present application, the battery module detection system 300 can determine the insulation abnormality between the plurality of cells inside the battery module 320 and the housing 330 by detecting the insulation resistance between the housing 330 and the internal cells.

In some feasible embodiments, in the case where the detection parameter includes the insulation resistance inside the battery module 320, the control circuit 301 can amplify the power supply signal according to a preset amplification factor to generate a first power supply voltage, and then transmit the first power supply voltage to the detection circuit 302. The detection circuit 302 can generate a first detection voltage under the action of the first power supply voltage and the voltage of the housing 330, and feed it back to the control circuit 301. Further, after receiving the first detection voltage, the control circuit 301 calculates the insulation resistance inside the battery module 320 by combining the first power supply voltage, the first detection voltage, and the resistance value of the resistance unit in the detection circuit 302.

In some feasible embodiments, to facilitate understanding of the principle by which the control circuit calculates the insulation resistance according to the above method, a detailed description is provided in an embodiment of the present application with reference to FIG. 4.

Specifically, reference is made to FIG. 4. FIG. 4 is a schematic structural diagram of a detection circuit provided in an embodiment of the present application. As shown in FIG. 4, the resistance unit of the detection circuit 400 includes a first resistor *R*₁, a second resistor *R*₂, a third resistor *R*₃, a fourth resistor *R*₄, and a fifth resistor *R*₅. One end of the first resistor *R*₁ is connected to a first port a1 of the control circuit 410, the other end of the first resistor *R*₁ is respectively connected to one end of the second resistor *R*₂, one end of the third resistor *R*₃, and one end of the fourth resistor *R*₄; the other end of the second resistor *R*₂ is connected to a second port a2 of the control circuit 410; the other end of the third resistor *R*₃ is grounded; the other end of the fourth resistor *R*₄ is respectively connected to the other end of the third resistor *R*₃ and one end of the fifth resistor *R*₅; and the other end of the fifth resistor *R*₅ is connected to the housing 430 of the battery module 420.

It will be understood that after generating the first power supply voltage, the control circuit 410 can transmit the first power supply voltage to the detection circuit 400 through the first port a1. The detection circuit 400 is connected to the housing 430 and can generate a corresponding first detection voltage under the action of the voltage of the housing 430 and the first power supply voltage. From the above description, this first detection voltage is related to the first power supply voltage, the internal voltage of the battery module 420, and the resistance values of the above-mentioned resistors. Further, the detection circuit 400 can feed the first detection voltage back to the control circuit 410 through the second port a2 of the control circuit 410.

In some feasible embodiments, the first detection voltage *U*₁ can be characterized by the following formula (1):
${U}_{1} = \frac{{V}_{1}}{{R}_{2} + \frac{{R}_{3} ∗ \left(R+1\right)}{{R}_{4} + {R}_{3} + R}} ∗ \frac{{R}_{3} ∗ \left(R+1\right)}{{R}_{4} + {R}_{3} + R}$ Formula (1)
where R is the resistance value of the insulation resistance inside the battery module 420, *U*₁ is the first detection voltage, *V*₁ is the first power supply voltage, *R*₁ is the resistance value of the first resistor, *R*₂ is the resistance value of the second resistor, *R*₃ is the resistance value of the third resistor, *R*₄ is the resistance value of the fourth resistor, and *R*₅ is the resistance value of the fifth resistor.

In some feasible embodiments, the control circuit 410 can be configured to, after receiving the first detection voltage *U*₁ fed back by the detection circuit 400, calculate the insulation resistance R inside the battery module 420 according to the following formula (2):
$R = \frac{{U}_{1} ∗ {V}_{1} ∗ \left({R}_{2}+{R}_{3}+{R}_{4}\right) ∗ \left({R}_{2}+{R}_{3}\right)}{\left({R}_{3}+{R}_{4}\right) ∗ \left({R}_{2}+{R}_{4}\right) + \left({R}_{2}+{R}_{3}+{R}_{4}\right) ∗ 2 {R}_{3} ∗ {U}_{1} ∗ 2 {R}_{2} + \left({R}_{2}+{R}_{4}\right) + \left({R}_{2}+{R}_{3}+{R}_{4}\right) ∗ 2 {R}_{3}}$ Formula (2)
where R is the resistance value of the insulation resistance inside the battery module 420, *U*₁ is the first detection voltage, *V*₁ is the first power supply voltage, *R*₁ is the resistance value of the first resistor, *R*₂ is the resistance value of the second resistor, *R*₃ is the resistance value of the third resistor, *R*₄ is the resistance value of the fourth resistor, and *R*₅ is the resistance value of the fifth resistor.

In summary, the control circuit 410 can generate and transmit the first power supply voltage to the detection circuit 400, receive the first detection signal fed back by the detection circuit 400, and then calculate the insulation resistance inside the battery module 420, i.e., the above-mentioned detection parameter, on the basis of the first power supply voltage, the first detection signal, and the respective resistance values of the resistors in the resistance unit of the detection circuit 400, thereby determining the insulation abnormality between the plurality of cells inside the battery module 420 and the housing 430 of the battery module 420 on the basis of this detection parameter.

In some feasible embodiments, in addition to calculating the insulation resistance inside the battery module 420 according to the above formula (2), the control circuit 410 shown in FIG. 4 can also calculate the insulation resistance according to the following method. In this case, the control circuit 410 can generate a first power supply voltage and a second power supply voltage according to a preset amplification factor, and then transmit the first power supply voltage and the second power supply voltage respectively to the detection circuit 400. The detection circuit 400 can generate a first detection voltage under the action of the first power supply voltage and the voltage of the housing 430, and feed it back to the control circuit 410. The detection circuit 400 can also generate a second detection voltage under the action of the second power supply voltage and the voltage of the housing 430, and feed it back to the control circuit 410. Further, after receiving the first detection voltage and the second detection voltage, the control circuit 410 calculates the insulation resistance inside the battery module 420 by combining the above-mentioned first power supply voltage, second power supply voltage, first detection voltage, second detection voltage, and the resistance values of the resistance unit in the detection circuit 400.

In some feasible embodiments, to facilitate understanding of the principle by which the above-mentioned control circuit 410 calculates the insulation resistance according to the above method, a detailed description is provided in an embodiment of the present application with reference to FIG. 4.

Specifically, reference is again made to FIG. 4. After generating the first power supply voltage, the control circuit 410 shown in FIG. 4 can transmit the first power supply voltage to the detection circuit 400 through the first port a1. The detection circuit 400 is connected to the housing 430 and can generate a corresponding first detection voltage under the action of the voltage of the housing 430 and the first power supply voltage. From the above description, this first detection voltage is related to the first power supply voltage, the internal voltage of the battery module 420, and the resistance values of the above-mentioned resistors. Further, the detection circuit 400 can feed the first detection voltage back through the second port a2 of the control circuit 410. Then, after receiving the first detection voltage, the control circuit 410 can generate a second power supply voltage and transmit the second power supply voltage to the detection circuit 400 through the first port a1. The detection circuit 400 can generate a corresponding second detection voltage under the action of the voltage of the housing 430 and the second power supply voltage. From the above description, this second detection voltage is related to the second power supply voltage, the internal voltage of the battery module 420, and the resistance values of the above-mentioned resistors. Further, the detection circuit 400 can feed the second detection voltage back through the second port a2 of the control circuit 410.

It will be noted that, in some feasible embodiments, the first detection voltage fed back by the detection circuit 400 can be characterized by the following formula (3):
${U}_{1} = \frac{{R}_{3} ∗ {U}_{x}}{{R}_{3} + {R}_{4} + {R}_{5}} + \frac{{V}_{1}}{{R}_{2} + \frac{1}{\frac{1}{{R}_{3}} + \frac{1}{{R}_{4} + {R}_{5} + R}}}$ Formula (3)
where *U*₁ is the first detection voltage, *V*₁ is the first power supply voltage, *R*₁ is the resistance value of the first resistor, *R*₂ is the resistance value of the second resistor, *R*₃ is the resistance value of the third resistor, *R*₄ is the resistance value of the fourth resistor, *R*₅ is the resistance value of the fifth resistor, and *Uₓ* is the internal voltage of the battery module 420.

Similarly, the second detection voltage can be characterized by the following formula (4):
${U}_{2} = \frac{{R}_{3} ∗ {U}_{x}}{{R}_{3} + {R}_{4} + {R}_{5}} + \frac{{V}_{2}}{{R}_{2} + \frac{1}{\frac{1}{{R}_{3}} + \frac{1}{{R}_{4} + {R}_{5} + R}}}$ Formula (4)
where *U*₂ is the second detection voltage, *V*₂ is the second power supply voltage, *R*₁ is the resistance value of the first resistor, *R*₂ is the resistance value of the second resistor, *R*₃ is the resistance value of the third resistor, *R*₄ is the resistance value of the fourth resistor, *R*₅ is the resistance value of the fifth resistor, and *Uₓ* is the internal voltage of the battery module 420.

In some feasible embodiments, the control circuit 410 can be configured to, after receiving the first detection voltage *U*₁ and the second detection voltage *U*₂ fed back by the detection circuit 400, calculate the insulation resistance R inside the battery module 420 according to the following formula (5):
$\begin{matrix}R = \frac{{R}_{3} ∗ {V}_{1} + {R}_{4} ∗ {V}_{1} - {R}_{3} ∗ {V}_{2} + {R}_{3} ∗ {V}_{1} - {R}_{4} ∗ {V}_{2} - {R}_{5} ∗ {V}_{2} + {R}_{2} ∗ {R}_{3} ∗ {U}_{1} - {R}_{2} ∗ {R}_{3} ∗ {U}_{2} + {R}_{2} ∗ {R}_{4} ∗ {U}_{1}}{{V}_{1} - {V}_{2} + {R}_{2} ∗ {U}_{1} - {R}_{2} ∗ {U}_{2} + {R}_{3} ∗ {U}_{1} - {R}_{3} ∗ {U}_{2}} \\ - \frac{{R}_{2} ∗ {R}_{4} ∗ {U}_{2} + {R}_{2} ∗ {R}_{5} ∗ {U}_{1} + {R}_{3} ∗ {R}_{4} ∗ {U}_{1} - {R}_{2} ∗ {R}_{5} ∗ {U}_{2} - {R}_{3} ∗ {R}_{4} ∗ {U}_{2} - {R}_{3} ∗ {R}_{5} ∗ {U}_{1} - {R}_{3} ∗ {R}_{5} ∗ {U}_{2}}{{V}_{1} - {V}_{2} + {R}_{2} ∗ {U}_{1} - {R}_{2} ∗ {U}_{2} + {R}_{3} ∗ {U}_{1} - {R}_{3} ∗ {U}_{2}}\end{matrix}$ Formula (5)
where R is the resistance value of the insulation resistance inside the battery module 420, *U*₁ is the first detection voltage, *U*₂ is the second detection voltage, *V*₁ is the first power supply voltage, *V*₂ is the second power supply voltage, *R*₁ is the resistance value of the first resistor, *R*₂ is the resistance value of the second resistor, *R*₃ is the resistance value of the third resistor, *R*₄ is the resistance value of the fourth resistor, and *R*₅ is the resistance value of the fifth resistor.

In summary, the control circuit can generate and transmit the first power supply voltage and the second power supply voltage respectively to the detection circuit, receive the first detection signal and the second detection signal fed back by the detection circuit respectively, and then calculate the insulation resistance inside the battery module, i.e., the above-mentioned detection parameter, on the basis of the first power supply voltage, the second power supply voltage, the first detection signal, the second detection signal, and the respective resistance values of the resistors in the resistance unit of the detection circuit, thereby determining the insulation abnormality between the plurality of cells inside the battery module and the housing of the battery module on the basis of this detection parameter.

In some feasible embodiments, after calculating the insulation resistance inside the battery module according to the above content, the control circuit can further determine the insulation abnormality between the plurality of cells inside the battery module and the housing on the basis of a comparison result between a preset resistance threshold and the insulation resistance. Specifically, the resistance threshold will be understood as the minimum value of the insulation resistance inside the battery module when there is no insulation abnormality inside the battery module. That is, when the insulation resistance inside the battery module is less than this resistance threshold, it indicates that an insulation abnormality is present inside the battery module. For example, in some application scenarios, this resistance threshold may be 1 megohm. Then, when the insulation resistance calculated by the control circuit is less than 1 megohm, the control circuit can determine that an insulation abnormality is present between the plurality of cells inside the battery module and the housing.

It will be understood that, in the case where there are multiple battery modules inside the power battery pack, the battery module detection system connected to each battery module can be used to detect the detection parameters inside the multiple battery modules (e.g., the insulation resistance), so as to determine the battery module in which an insulation abnormality has occurred, facilitating the repair and replacement of the faulty battery module.

In some feasible embodiments, the battery module detection system provided in the embodiments of the present application can not only determine the battery module in which an insulation abnormality has occurred in the power battery pack, but also determine the abnormally operating cell within the battery module in which the insulation abnormality has occurred, so that maintenance personnel can directly repair or replace the abnormally operating cell in that battery module, thereby saving maintenance costs.

Specifically, reference is again made to FIG. 4. As shown in FIG. 4, the battery module 420 includes a plurality of cells: cell BT1, cell BT2, and cell BT3. The positive electrode of cell BT1 is connected to the negative electrode of cell BT2 at point a, the positive electrode of cell BT2 is connected to the negative electrode of cell BT3 at point b, and the positive electrode of cell BT3 is connected to the BC terminal-pole of the battery module 420 at point c. It will be noted that, since the plurality of cells are connected in series, the voltage distribution at points a, b, and c conforms to the distribution characteristics of a series-connected battery circuit. Therefore, under normal operation of the battery module 420, the normal voltage at point c > the normal voltage at point b > the normal voltage at point a. For example, when the output voltage of each of the plurality of cells is 5 volts, the normal voltage at point a is equal to the output voltage of cell BT1, i.e., 5 volts; the normal voltage at point b is equal to the sum of the output voltages of cell BT1 and cell BT2, i.e., 10 volts; and the normal voltage at point c is equal to the sum of the output voltages of cell BT1, cell BT2, and cell BT3, i.e., 15 volts.

It will be understood that when none of the plurality of cells of the battery module 420 is abnormal, the plurality of cells are insulated from the housing 430. At this time, the output voltages of the plurality of cells are not applied to the housing 430, and the voltage of the housing 430 is less than a preset housing voltage threshold. This housing voltage threshold will be understood as the minimum voltage value when the housing 430 is electrically charged. When the voltage of the housing 430 is greater than this housing voltage threshold, it indicates that the housing 430 is electrically charged. It will be understood that when a cell of the battery module 420 operates abnormally, the abnormally operating cell is no longer insulated from the housing 430, i.e., the abnormally operating cell transmits its output voltage to the housing 430 through the insulation resistance. For example, when an abnormality such as leakage, micro-short circuit, etc. occurs in cell BT1, cell BT1 is electrically connected to the housing 430 of the battery module 420 through the insulation resistance R, which can be equivalent to the output voltage of cell BT1 (i.e., the normal voltage at point a) being applied to the housing 430 through the insulation resistance. Similarly, when an abnormality such as leakage, micro-short circuit, etc. occurs in cell BT2, cell BT2 is electrically connected to the housing 430 of the battery module 420 through the insulation resistance R, which can be equivalent to the sum of the output voltages of cell BT1 and cell BT2 (i.e., the normal voltage at point b) being applied to the housing 430 through the insulation resistance. When an abnormality such as leakage, micro-short circuit, etc. occurs in cell BT3, cell BT3 is electrically connected to the housing 430 of the battery module 420 through the insulation resistance R, which can be equivalent to the sum of the output voltages of cell BT1, cell BT2, and cell BT3 (i.e., the normal voltage at point c) being applied to the housing 430 through the insulation resistance. That is, when different cells in the battery module 420 have an abnormality, the voltages correspondingly applied to the housing 430 are also different. To this end, the battery module detection system in the embodiment of the present application can calculate, by detecting the battery module 420, the voltage applied to the housing 430 inside the battery module 420, and determine this voltage as the insulation voltage *Uₓ* of the battery module 420. This insulation voltage *Uₓ* will be understood as the voltage carried by the housing 430 due to the abnormally operating cell when an insulation abnormality occurs in a cell inside the battery module 420, such as the output voltage of cell BT1 or the combined output voltage of cell BT1 and cell BT2.

In some feasible embodiments, to determine whether an insulation abnormality has occurred in the battery module 420 and to determine the abnormally operating cell in the abnormal battery module 420, the control circuit 410 can calculate the insulation voltage and the insulation resistance inside the battery module 420 on the basis of the power supply voltage, the detection voltage, and the resistance values of the resistance unit, i.e., the detection parameters inside the battery module 420 include the insulation voltage and the insulation resistance. Then, whether an insulation abnormality has occurred inside the battery module 420 is determined on the basis of the insulation resistance, and the cell with the insulation abnormality inside the battery module 420 is determined on the basis of the insulation equivalent voltage.

It will be understood that the specific implementation of calculating the insulation resistance inside the battery module 420 by the control circuit 410 can be referred to in the above content, and will not be repeated in the present application. Further, after calculating the insulation resistance inside the battery module 420, from the above description, when the insulation resistance is less than the preset resistance threshold, the control circuit 410 can determine that an insulation abnormality is present between the plurality of cells inside the battery module 420 and the housing 430, i.e., an abnormality is present in the operation of a cell among the plurality of cells inside the battery module 420. Further, the control circuit 410 can calculate the insulation voltage inside the battery module 420 on the basis of the power supply voltage, the detection voltage, and the resistance values of the resistance unit of the detection circuit 400.

Specifically, in the case where the resistance unit of the detection circuit 400 is as shown in FIG. 4, the control circuit 410 can calculate the above-mentioned insulation voltage according to the following content. First, after generating the first power supply voltage, the control circuit 410 can transmit the first power supply voltage to the detection circuit 400 through the first port a1. The detection circuit 400 is connected to the housing 430 and can generate a corresponding first detection voltage under the action of the voltage of the housing 430 and the first power supply voltage. From the above description, this first detection voltage is related to the first power supply voltage, the internal voltage of the battery module 420, and the resistance values of the above-mentioned resistors. Further, the detection circuit 400 can feed the first detection voltage back through the second port a2 of the control circuit 410. Then, after receiving the first detection voltage, the control circuit 410 can generate a second power supply voltage and transmit the second power supply voltage to the detection circuit 400 through the first port a1. The detection circuit 400 can generate a corresponding second detection voltage under the action of the voltage of the housing 430 and the second power supply voltage. From the above description, this second detection voltage is related to the second power supply voltage, the internal voltage of the battery module 420, and the resistance values of the above-mentioned resistors. Further, the detection circuit 400 can feed the second detection voltage back through the second port a2 of the control circuit 410.

It will be noted that the first detection voltage fed back by the detection circuit 400 can be characterized by the above-mentioned formula (3), and the second detection voltage can be characterized by the above-mentioned formula (4), which will not be repeated in the present application.

In some feasible embodiments, the control circuit 410 can be configured to, after receiving the first detection voltage *U*₁ and the second detection voltage *U*₂ fed back by the detection circuit 400, calculate the insulation voltage *Uₓ* inside the battery module 420 according to the following formula (6):
${U}_{x} = \frac{{R}_{3} ∗ {U}_{1} ∗ {V}_{1} + {R}_{4} ∗ {U}_{1} ∗ {V}_{1} + {R}_{5} ∗ {U}_{1} ∗ {V}_{1} - {R}_{3} ∗ {U}_{2} ∗ {V}_{2} - {R}_{4} ∗ {U}_{2} ∗ {V}_{2} - {R}_{5} ∗ {U}_{2} ∗ {V}_{2}}{{R}_{3} ∗ {U}_{1} - {R}_{2} ∗ {U}_{2}}$ Formula (6)
where *Uₓ* is the insulation voltage, *U*₁ is the first detection voltage, *U*₂ is the second detection voltage, *V*₁ is the first power supply voltage, *V*₂ is the second power supply voltage, *R*₁ is the resistance value of the first resistor, *R*₂ is the resistance value of the second resistor, *R*₃ is the resistance value of the third resistor, *R*₄ is the resistance value of the fourth resistor, and *R*₅ is the resistance value of the fifth resistor.

It will be understood that when all the plurality of cells in the battery module 420 are operating normally, the plurality of cells are insulated from the housing 430. At this time, the insulation voltage calculated by the control circuit 410 is less than a preset insulation voltage threshold. This insulation voltage threshold will be understood as the minimum voltage applied to the insulation voltage and the housing when a cell in the battery module 420 operates abnormally. That is, when the insulation voltage calculated by the control circuit 410 is less than the insulation voltage threshold, it can be determined that there is no abnormally operating cell in the battery module 420. Further, when the insulation voltage calculated by the control circuit 410 is greater than the insulation voltage threshold, it can be determined that there is an abnormally operating cell in the battery module 420. The abnormally operating cell is no longer insulated from the housing 430, i.e., the abnormally operating cell applies its output voltage to the housing 430 through the insulation resistance. Therefore, the control circuit 410 can determine the cell in which the abnormality has occurred on the basis of the calculated insulation voltage and the output voltages corresponding to the plurality of cells.

Specifically, the control circuit 410 may preset a plurality of voltage threshold intervals. It will be noted that the preset plurality of voltage threshold intervals will be understood as a plurality of voltage threshold intervals respectively corresponding to the plurality of cells in the battery module 420. For example, the battery module 420 shown in FIG. 4 includes a cell BT1, a cell BT2, and a cell BT3. From the above description, when the output voltages of the plurality of cells are all 5 volts, when the cell BT1 has an insulation abnormality, the output voltage of the cell BT1 is applied to the housing 430 through the insulation resistance. At this time, the calculated insulation voltage is close to the output voltage of the cell BT1, which is 5 volts. Therefore, the control circuit 410 may determine the voltage threshold interval corresponding to the cell BT1 as an interval with 5 volts as the mean, for example, 3 volts to 7 volts. It will be understood that when the calculated insulation voltage of the battery module 420 is equal to 6 volts, it can be determined that the cell BT1 of the battery module 420 is abnormal.

Similarly, when the cell BT2 has an insulation abnormality, the cell BT2 is connected in series with the cell BT1, and the sum of the output voltages of the cell BT1 and the cell BT2 is applied to the housing 430 through the insulation resistance. At this time, the calculated insulation voltage is close to the sum of the output voltages of the cell BT1 and the cell BT2, which is 10 volts. Therefore, the control circuit 410 may determine the voltage threshold interval corresponding to the cell BT2 as an interval with 10 volts as the mean, for example, 8 volts to 12 volts. It will be understood that when the calculated insulation voltage of the battery module 420 is equal to 9 volts, it can be determined that the cell BT2 of the battery module 420 is abnormal.

Similarly, when the cell BT3 has an insulation abnormality, the cell BT3 is connected in series with the cell BT2 and the cell BT1, and the sum of the output voltages of the cell BT1, the cell BT2, and the cell BT3 is applied to the housing 430 through the insulation resistance. At this time, the calculated insulation voltage is close to the sum of the output voltages of the cell BT1, the cell BT2, and the cell BT3, which is 15 volts. Therefore, the control circuit 410 may determine the voltage threshold interval corresponding to the cell BT3 as an interval with 15 volts as the mean, for example, 13 volts to 17 volts. It will be understood that when the calculated insulation voltage of the battery module 420 is equal to 14 volts, it can be determined that the cell BT3 of the battery module 420 is abnormal.

In summary, the control circuit 410 may determine the voltage threshold interval corresponding to each cell on the basis of the output voltages of the plurality of cells connected in series inside the battery module 420. The voltage threshold intervals of the above-mentioned cell BT1, cell BT2, and cell BT3 are only examples, and are not exhaustively described in the present application. It will be noted that, in order to avoid errors in determining the abnormally operating cell, when presetting the voltage threshold intervals corresponding to each cell, the control circuit 410 should ensure that the voltage threshold intervals corresponding to each cell do not overlap with each other.

It will be understood that after calculating the insulation voltage inside the battery module 420, the control circuit 410 may determine, among the preset plurality of voltage threshold intervals, a voltage threshold interval corresponding to the insulation voltage as a target voltage threshold interval. Herein, the target voltage threshold interval will be understood as a voltage threshold interval that includes the calculated insulation voltage. For example, assuming that the voltage threshold interval corresponding to the cell BT1 is 3 volts to 7 volts, when the control circuit 410 calculates an insulation voltage of 7 volts, it can be determined that the voltage threshold interval of 3 volts to 7 volts corresponding to the cell BT1 is the target voltage threshold interval. Further, the control circuit 410 may determine the cell corresponding to the target voltage threshold interval as the cell having the insulation abnormality, i.e., the cell BT1 is determined as the cell having the insulation abnormality.

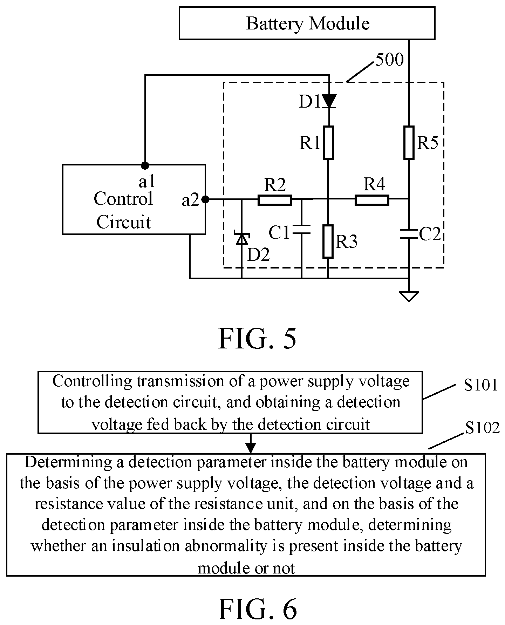

In some feasible embodiments, reference is made to FIG. 5. FIG. 5 is another schematic structural diagram of a detection circuit provided in an embodiment of the present application. As shown in FIG. 5, the detection circuit 500 further includes a first capacitor *C*₁ and a second capacitor *C*₂. The first capacitor *C*₁ is connected in parallel with the above-mentioned third resistor *R*₃, one end of the second capacitor *C*₂ is connected to the other end of the fourth resistor *R*₄, and the other end of the second capacitor *C*₂ is grounded. It will be noted that the first capacitor *C*₁ is a filter capacitor, which can filter out interference signals in the detection circuit 500, avoiding interference with the detection parameters. The second capacitor *C*₂ is a parasitic capacitor in the detection circuit 500.

In some feasible embodiments, reference is again made to FIG. 5. The detection circuit 500 shown in FIG. 5 further includes a first diode *D*₁ and a second diode *D*₂. One end of the first diode *D*₁ is connected to the first port a1 of the control circuit, and the other end of the first diode *D*₁ is connected to one end of the second resistor *R*₂. One end of the second diode *D*₂ is connected to the second port a2 of the control circuit, and the other end of the second diode *D*₂ is grounded. It will be noted that the first diode *D*₁ may be a reverse diode, which can prevent the voltage in the detection circuit 500 from affecting the first port a1 of the control circuit. The second diode *D*₂ may be a Zener diode, which can prevent the voltage in the detection circuit 500 from affecting the second port a2 of the control circuit, thereby ensuring the stability of the detection circuit 500.

In some feasible embodiments, from the above description, the detection circuit in the battery module detection system is composed of resistor-capacitor components (resistors and capacitors), having a simple structure and being easy to implement. Moreover, the cost of the resistor-capacitor components is low, thereby saving development costs.

In the embodiment of the present application, in the case where the power battery pack includes a plurality of battery modules, the battery module detection system connected to each battery module can respectively detect the insulation resistances of the plurality of battery modules, so as to determine the insulation abnormality inside the plurality of battery modules on the basis of the insulation resistances and a preset resistance threshold, thereby determining the battery module with an insulation abnormality among the plurality of battery modules. Further, the battery module with the insulation abnormality can be repaired or replaced. It will be understood that when it is determined that a battery module has an insulation abnormality, the battery module detection system can also calculate the insulation voltage of the battery module, and then, on the basis of the insulation voltage of the battery module and a plurality of preset voltage threshold intervals, determine the cell with the insulation abnormality among the plurality of cells of the battery module, facilitating maintenance personnel to repair or replace the abnormal cell in the battery module, thereby improving the safety and stability of the battery module.

An embodiment of the present application further provides a battery module detection method. Reference is made to FIG. 6. FIG. 6 is a schematic flowchart of the battery module detection method provided in the present application. The battery module detection method provided in the embodiment of the present application is applicable to the battery module detection system shown in FIG. 3 to FIG. 5. It will be noted that the detection method shown in FIG. 6 may be performed by the control circuit shown in FIG. 3 to FIG. 5. Specifically, the battery module detection method may at least include the following steps:
S101. A power supply voltage is controlled to be transmitted to a detection circuit, and a detection voltage fed back by the detection circuit is obtained.

In some feasible embodiments, the detection circuit includes a resistance unit. Further, from the above description, the detection circuit can receive the power supply voltage generated by the control circuit. When the internal voltage of the battery module changes, causing the voltage of the housing to also change, the detection circuit can generate a corresponding detection voltage under the action of the voltage of the housing and the power supply voltage.

For the specific implementation of the above-mentioned S101, reference may be made to the implementation performed by the control circuit in FIG. 3 to FIG. 5, and details thereof are not repeated in the embodiment of the present application.

S102. A detection parameter inside the battery module is determined on the basis of the power supply voltage, the detection voltage, and the resistance value of the resistance unit, and on the basis of the detection parameter inside the battery module, whether an insulation abnormality is present inside the battery module is determined.

In some feasible embodiments, the resistance unit can generate different detection voltages under different voltages of the housing and different power supply voltages. Therefore, the detection circuit can feed this detection voltage back to the control circuit, so that the control circuit can, on the basis of the generated power supply voltage, the received detection voltage, and the resistance value of the resistance unit in the detection circuit, back-calculate the internal voltage of the battery module, and thereby determine the insulation abnormality inside the battery module.

In some feasible embodiments, in the embodiment of the present application, the battery module detection system can determine the insulation abnormality between the plurality of cells inside the battery module and the housing by detecting the insulation resistance between the housing and the internal cells.

In some feasible embodiments, in the case where the detection parameter includes the insulation resistance inside the battery module, the control circuit can amplify the power supply signal according to a preset amplification factor to generate a first power supply voltage, and then transmit the first power supply voltage to the detection circuit. The detection circuit can generate a first detection voltage under the action of the first power supply voltage and the voltage of the housing, and feed it back to the control circuit. Further, after receiving the first detection voltage, the control circuit calculates the insulation resistance inside the battery module by combining the first power supply voltage, the first detection voltage, and the resistance value of the resistance unit in the detection circuit.

In some feasible embodiments, the control circuit can also generate and transmit the first power supply voltage and the second power supply voltage respectively to the detection circuit, receive the first detection signal and the second detection signal fed back by the detection circuit respectively, and then calculate the insulation resistance inside the battery module, i.e., the detection parameter, on the basis of the first power supply voltage, the second power supply voltage, the first detection signal, the second detection signal, and the respective resistance values of the resistors in the resistance unit of the detection circuit, thereby determining the insulation abnormality between the plurality of cells inside the battery module and the housing of the battery module on the basis of this detection parameter.

In some feasible embodiments, after calculating the insulation resistance inside the battery module according to the above content, the control circuit can further determine the insulation abnormality between the plurality of cells inside the battery module and the housing on the basis of a comparison result between a preset resistance threshold and the insulation resistance.

In some feasible embodiments, the battery module detection method provided in the embodiment of the present application further includes presetting a voltage threshold interval corresponding to each cell, and after calculating the insulation voltage inside the battery module, determining, among the preset plurality of voltage threshold intervals, the voltage threshold interval corresponding to the insulation voltage as a target voltage threshold interval. Further, the control circuit may determine the cell corresponding to the target voltage threshold interval as the cell having the insulation abnormality, so that maintenance personnel can directly repair or replace the abnormally operating cell in the battery module, thereby saving maintenance costs.

For the specific implementation of the above-mentioned S102, reference may be made to the implementation performed by the control circuit in FIG. 3 to FIG. 5, and details thereof are not repeated in the embodiment of the present application.

An embodiment of the present application further provides a non-volatile computer-readable storage medium. The non-volatile computer-readable storage medium stores a computer program. The computer program is executed by a processor to implement the operations performed by the control circuit in the method of any of the preceding embodiments in FIG. 6 and possible method embodiments thereof.

An embodiment of the present application further provides a computer program product. When the computer program product is read and executed by a computer, the operations performed by the control circuit in the method of any of the preceding embodiments in FIG. 6 and possible method embodiments thereof will be executed.

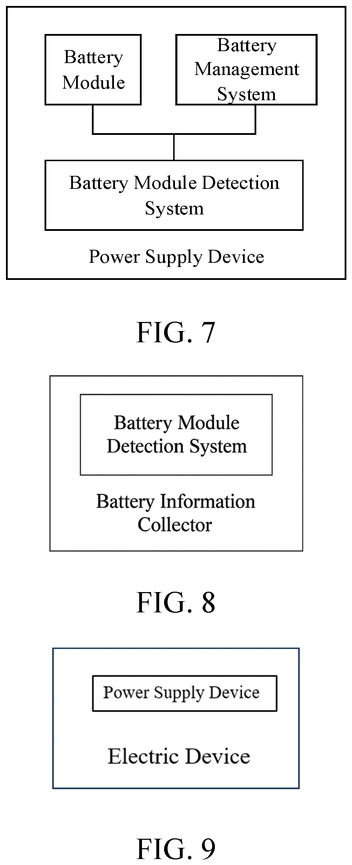

An embodiment of the present application further provides a power supply device. Reference is made to FIG. 7. FIG. 7 is a schematic structural diagram of a power supply device provided in an embodiment of the present application. In FIG. 7, the power supply device includes a battery module, a battery management system, and the battery module detection system in the various possible embodiments described above. The battery module is electrically connected to the battery module detection system and the battery management system, respectively. The battery module detection system is configured to detect an insulation abnormality inside the battery module, and generate a detection result based on the insulation abnormality inside the battery module. The battery module detection system is connected to the battery management system and can send the detection result to the battery management system. Further, the battery management system can output an abnormality prompt or a normal prompt on the basis of the detection result.

In some feasible embodiments, the battery module includes at least two cells connected in series. Specifically, reference may be made to the specific implementation of the battery module shown in FIG. 3 and FIG. 4, and details thereof are not repeated in the present application.

It can be seen that the content in the battery module detection system embodiments is applicable to the embodiments of the present power supply device. The specific functions implemented by the embodiments of the present power supply device are the same as those of the battery module detection system embodiments, and the beneficial effects achieved are also the same as those achieved by the battery module detection system embodiments.

An embodiment of the present application further provides a battery information collector. Reference is made to FIG. 8. The battery information collector includes the battery module detection system in the various possible embodiments described above.

It can be seen that the content in the battery module detection system embodiments is applicable to the embodiments of the present battery information collector. The specific functions implemented by the embodiments of the present battery information collector are the same as those of the battery module detection system embodiments, and the beneficial effects achieved are also the same as those achieved by the battery module detection system embodiments.

An embodiment of the present application further provides an electric device. Reference is made to FIG. 9. The electric device includes the power supply device in the various possible embodiments described above. Exemplarily, in some application scenarios, the electric device may be an electric vehicle, a household appliance, a terminal device, or other electric device having a battery module, which is not limited in the embodiment of the present application.

It can be seen that the content in the power supply device embodiments is applicable to the embodiments of the present electric device. The specific functions implemented by the embodiments of the present electric device are the same as those of the power supply device embodiments, and the beneficial effects achieved are also the same as those achieved by the power supply device embodiments.

It will be noted that, for the sake of simple description, the foregoing method embodiments are described as a series of action combinations. However, a person skilled in the art will appreciate that the present application is not limited by the described order of actions, because certain steps may be performed in other orders or simultaneously according to the present application. Moreover, a person skilled in the art will also appreciate that the embodiments described in the specification are all preferred embodiments, and the actions and modules involved are not necessarily required in the present application.

In the embodiments provided in the present application, it will be understood that the disclosed system may be implemented in other ways. For example, the system embodiments described above are merely illustrative. For instance, the division of the above-mentioned modules is merely a logical function division, and other division manners may be used in actual implementation. For example, multiple units or components may be combined or integrated into another system, or some features may be ignored or not performed. Another point is that the mutual coupling, direct coupling, or communication connections shown or discussed may be indirect coupling or communication connections through some interfaces, systems, or units, and may be electrical or other forms.

The modules described as separate components may or may not be physically separated. The components displayed as modules may or may not be physical modules, i.e., they may be located in one place or distributed over multiple network modules. Some or all of the modules may be selected according to actual needs to achieve the objectives of the solutions of the embodiments.

In addition, functional modules in the various embodiments of the present application may be integrated into one processing module, or each module may exist separately physically, or two or more modules may be integrated into one module. The above-mentioned integrated modules may be implemented in the form of hardware or in the form of software functional modules.

The above describes the embodiments of the present application in detail. Specific examples are used herein to illustrate the principles and implementation manners of the present application. The description of the above embodiments is only for helping to understand the present application and its core ideas. Meanwhile, for a person of ordinary skill in the art, there will be changes in the specific implementation manners and application scopes according to the ideas of the present application. In summary, the content of the present specification will not be construed as limiting the present application.

## Claims

1. A battery module detection system (300), comprising a control circuit (301) and a detection circuit (302), wherein the detection circuit (302) is configured to electrically connect to a housing (330) of a battery module (320), the detection circuit (302) comprises a resistance unit, the control circuit (301) is connected to the detection circuit (302), and the control circuit (301) is configured to:
control transmission of a power supply voltage to the detection circuit (302) and obtain a detection voltage fed back by the detection circuit (302); and
determine a detection parameter inside the battery module (320) on the basis of the power supply voltage, the detection voltage and a resistance value of the resistance unit, and on the basis of the detection parameter inside the battery module (320), determine whether an insulation abnormality is present inside the battery module (320).

2. The system (300) according to claim 1, wherein the power supply voltage comprises a first power supply voltage, and the detection voltage comprises a first detection voltage fed back by the detection circuit (302); the detection parameter inside the battery module (320) comprises an insulation resistance of the battery module (320); and
the control circuit (301) is configured to determine the insulation resistance of the battery module (320) on the basis of the first power supply voltage, the first detection voltage and the resistance value of the resistance unit, and on the basis of the insulation resistance of the battery module (320) and a preset resistance threshold, determine whether an insulation abnormality is present between a plurality of cells inside the battery module (320) and the housing (330) of the battery module (320).

3. The system (300) according to claim 1 or 2, wherein the power supply voltage comprises a first power supply voltage and a second power supply voltage, and the detection voltage comprises a first detection voltage and a second detection voltage, the first detection voltage being a detection voltage fed back by the detection circuit (302) when the power supply voltage is the first power supply voltage; the second detection voltage being a detection voltage fed back by the detection circuit (302) when the power supply voltage is the second power supply voltage; the detection parameter inside the battery module (320) comprises an insulation resistance of the battery module (320); and
the control circuit (301) is configured to determine the insulation resistance of the battery module (320) on the basis of the first power supply voltage, the second power supply voltage, the first detection voltage, the second detection voltage and the resistance value of the resistance unit, and on the basis of the insulation resistance of the battery module (320) and a preset resistance threshold, determine whether an insulation abnormality is present between a plurality of cells inside the battery module (320) and the housing (330) of the battery module (320).

4. The system (300) according to claim 3, wherein the detection parameter inside the battery module (320) further comprises an insulation voltage of the battery module (320); and
the control circuit (301) is configured to determine the insulation voltage of the battery module (320) on the basis of the first power supply voltage, the second power supply voltage, the first detection voltage, the second detection voltage and the resistance value of the resistance unit, and when the insulation resistance is less than the preset resistance threshold, determine a cell having an insulation abnormality from among the plurality of cells inside the battery module (320) on the basis of the insulation voltage of the battery module (320).

5. The system (300) according to any one of claims 2 to 4, wherein the control circuit (301) is configured to, when the insulation resistance is less than the preset resistance threshold, determine a cell corresponding to an obtained target voltage threshold interval inside the battery module (320) as the cell having the insulation abnormality.

6. The system (300) according to any one of claims 1 to 5, wherein the resistance unit comprises a first resistor, a second resistor, a third resistor, a fourth resistor and a fifth resistor;
one end of the first resistor is connected to a first port of the control circuit (301), the other end of the first resistor is respectively connected to one end of the second resistor, one end of the third resistor and one end of the fourth resistor, the other end of the second resistor is connected to a second port of the control circuit (301), the other end of the third resistor, the other end of the fourth resistor, and one end of the fifth resistor are all grounded, and the other end of the fifth resistor is connected to the housing (330) of the battery module (320); and
the control circuit (301) is configured to transmit the power supply voltage through the first port and obtain the detection voltage through the second port.

7. The system (300) according to claim 6, wherein the power supply voltage comprises a first power supply voltage, and the detection voltage comprises a first detection voltage fed back by the detection circuit (302); the control circuit (301) being configured to determine the insulation resistance of the battery module (320) on the basis of the first power supply voltage, the first detection voltage and the resistance value of the resistance unit, comprises:
the control circuit (301) being configured to calculate the insulation resistance inside the battery module (320) according to the following formula: $R = \frac{{U}_{1} ∗ {V}_{1} ∗ \left({R}_{2}+{R}_{3}+{R}_{4}\right) ∗ \left({R}_{2}+{R}_{3}\right)}{\left({R}_{3}+{R}_{4}\right) ∗ \left({R}_{2}+{R}_{4}\right) + \left({R}_{2}+{R}_{3}+{R}_{4}\right) ∗ 2 {R}_{3} ∗ {U}_{1} ∗ 2 {R}_{2} + \left({R}_{2}+{R}_{4}\right) + \left({R}_{2}+{R}_{3}+{R}_{4}\right) ∗ 2 {R}_{3}}$
wherein, R is a resistance value of the insulation resistance, *U*₁ is the first detection voltage, *V*₁ is the first power supply voltage, *R*₁ is a resistance value of the first resistor, *R*₂ is a resistance value of the second resistor, *R*₃ is a resistance value of the third resistor, *R*₄ is a resistance value of the fourth resistor, and *R*₅ is a resistance value of the fifth resistor.

8. The system according to claim 6 or 7, wherein the power supply voltage comprises a first power supply voltage and a second power supply voltage, and the detection voltage comprises a first detection voltage and a second detection voltage; the control circuit (301) being configured to determine the insulation resistance of the battery module (320) on the basis of the first power supply voltage, the second power supply voltage, the first detection voltage, the second detection voltage and the resistance value of the resistance unit, comprises:
the control circuit (301) being configured to calculate the insulation resistance of the battery module (320) according to the following formula: $\begin{matrix}R = \frac{{R}_{3} ∗ {V}_{1} + {R}_{4} ∗ {V}_{1} - {R}_{3} ∗ {V}_{2} + {R}_{3} ∗ {V}_{1} - {R}_{4} ∗ {V}_{2} - {R}_{5} ∗ {V}_{2} + {R}_{2} ∗ {R}_{3} ∗ {U}_{1} - {R}_{2} ∗ {R}_{3} ∗ {U}_{2} + {R}_{2} ∗ {R}_{4} ∗ {U}_{1}}{{V}_{1} - {V}_{2} + {R}_{2} ∗ {U}_{1} - {R}_{2} ∗ {U}_{2} + {R}_{3} ∗ {U}_{1} - {R}_{3} ∗ {U}_{2}} \\ - \frac{{R}_{2} ∗ {R}_{4} ∗ {U}_{2} + {R}_{2} ∗ {R}_{5} ∗ {U}_{1} + {R}_{3} ∗ {R}_{4} ∗ {U}_{1} - {R}_{2} ∗ {R}_{5} ∗ {U}_{2} - {R}_{3} ∗ {R}_{4} ∗ {U}_{2} - {R}_{3} ∗ {R}_{5} ∗ {U}_{1} - {R}_{3} ∗ {R}_{5} ∗ {U}_{2}}{{V}_{1} - {V}_{2} + {R}_{2} ∗ {U}_{1} - {R}_{2} ∗ {U}_{2} + {R}_{3} ∗ {U}_{1} - {R}_{3} ∗ {U}_{2}}\end{matrix}$
wherein, R is a resistance value of the insulation resistance, *U*₁ is the first detection voltage, *U*₂ is the second detection voltage, *V*₁ is the first power supply voltage, *V*₂ is the second power supply voltage, *R*₁ is a resistance value of the first resistor, *R*₂ is a resistance value of the second resistor, *R*₃ is a resistance value of the third resistor, *R*₄ is a resistance value of the fourth resistor, and *R*₅ is a resistance value of the fifth resistor.

9. The system (300) according to any one of claims 6 to 8, wherein the power supply voltage comprises a first power supply voltage and a second power supply voltage, and the detection voltage comprises a first detection voltage and a second detection voltage; the control circuit (301) is configured to calculate the insulation voltage of the battery module (320) according to the following formula: ${U}_{x} = \frac{{R}_{3} ∗ {U}_{1} ∗ {V}_{1} + {R}_{4} ∗ {U}_{1} ∗ {V}_{1} + {R}_{5} ∗ {U}_{1} ∗ {V}_{1} - {R}_{3} ∗ {U}_{2} ∗ {V}_{2} - {R}_{4} ∗ {U}_{2} ∗ {V}_{2} - {R}_{5} ∗ {U}_{2} ∗ {V}_{2}}{{R}_{3} ∗ {U}_{1} - {R}_{2} ∗ {U}_{2}}$ wherein, *Uₓ* is the insulation voltage, *U*₁ is the first detection voltage, *U*₂ is the second detection voltage, *V*₁ is the first power supply voltage, *V*₂ is the second power supply voltage, *R*₁ is a resistance value of the first resistor, *R*₂ is a resistance value of the second resistor, *R*₃ is a resistance value of the third resistor, *R*₄ is a resistance value of the fourth resistor, and *R*₅ is a resistance value of the fifth resistor.

10. The system (300) according to any one of claims 6 to 9, wherein the detection circuit (302) further comprises a first capacitor (*C*₁) and a second capacitor (*C*₂); and
the first capacitor (*C*₁) is connected in parallel with the third resistor, one end of the second capacitor (*C*₂) is connected to the other end of the fourth resistor, and the other end of the second capacitor (*C*₂) is grounded.

11. The system (300) according to any one of claims 6 to 10, wherein the detection circuit (302) further comprises a first diode (*D*₁) and a second diode (*D*₂); and
an anode of the first diode (*D*₁) is connected to the first port of the control circuit (301), a cathode of the first diode (*D*₁) is connected to one end of the second resistor; a cathode of the second diode *D*₂) is connected to the second port of the control circuit (301), and an anode of the second diode (*D*₂) is grounded.

12. A battery module detection method, performed by a battery module detection system, the battery module detection system comprising a control circuit and a detection circuit connected to the control circuit, the detection circuit being electrically connected to a housing of a battery module and comprising a resistance unit, the method comprising:
the control circuit controlling (S101) transmission of a power supply voltage to the detection circuit, and obtaining a detection voltage fed back by the detection circuit; and
the control circuit determining a detection parameter inside the battery module on the basis of the power supply voltage, the detection voltage and a resistance value of the resistance unit, and on the basis of the detection parameter inside the battery module, determining (S102) whether an insulation abnormality is present inside the battery module.

13. The method according to claim 12, wherein the power supply voltage comprises a first power supply voltage, and the detection voltage comprises a first detection voltage fed back by the detection circuit; the detection parameter inside the battery module comprises an insulation resistance of the battery module;
determining the detection parameter inside the battery module on the basis of the power supply voltage, the detection voltage and the resistance value of the resistance unit, and on the basis of the detection parameter inside the battery module, determining whether the insulation abnormality is present inside the battery module comprises:
determining the insulation resistance of the battery module on the basis of the first power supply voltage, the first detection voltage and the resistance value of the resistance unit, and on the basis of the insulation resistance of the battery module and a preset resistance threshold, determining whether an insulation abnormality is present between a plurality of cells inside the battery module and the housing of the battery module.

14. The method according to claim 13, wherein the power supply voltage comprises a first power supply voltage and a second power supply voltage, and the detection voltage comprises a first detection voltage and a second detection voltage, the first detection voltage being a detection voltage fed back by the detection circuit when the power supply voltage is the first power supply voltage; the second detection voltage being a detection voltage fed back by the detection circuit when the power supply voltage is the second power supply voltage; the detection parameter inside the battery module comprises an insulation resistance of the battery module;
determining the detection parameter inside the battery module on the basis of the power supply voltage, the detection voltage and the resistance value of the resistance unit, and on the basis of the detection parameter inside the battery module, determining whether the insulation abnormality is present inside the battery module, comprises:
determining the insulation resistance of the battery module on the basis of the first power supply voltage, the second power supply voltage, the first detection voltage, the second detection voltage and the resistance value of the resistance unit, and on the basis of the insulation resistance of the battery module and a preset resistance threshold, determining whether an insulation abnormality is present between a plurality of cells inside the battery module and the housing of the battery module.

15. The method according to claim 13 or 14, wherein the power supply voltage comprises a first power supply voltage and a second power supply voltage, the detection voltage comprises a first detection voltage and a second detection voltage, and the detection parameter inside the battery module further comprises an insulation voltage of the battery module;
determining the detection parameter inside the battery module on the basis of the power supply voltage, the detection voltage and the resistance value of the resistance unit, and on the basis of the detection parameter inside the battery module, determining whether the insulation abnormality is present inside the battery module, comprises:
the control circuit being configured to determine the insulation voltage of the battery module on the basis of the first power supply voltage, the second power supply voltage, the first detection voltage, the second detection voltage and the resistance value of the resistance unit, and when the insulation resistance is less than the preset resistance threshold, determine a cell having an insulation abnormality from among the plurality of cells inside the battery module on the basis of the insulation voltage of the battery module.

16. The method according to any one of claims 13 to 15, wherein when the insulation resistance is less than the preset resistance threshold, determining a cell having an insulation abnormality from among the plurality of cells inside the battery module on the basis of the insulation voltage of the battery module, comprises:
when the insulation resistance is less than the preset resistance threshold, determining a cell corresponding to an obtained target voltage threshold interval inside the battery module as the cell having the insulation abnormality.

17. A non-volatile computer-readable storage medium, wherein a computer program is stored in the non-volatile computer-readable storage medium, the computer program being suitable for being loaded and executed by a processor, so as to cause a computer device having the processor to perform the method according to any one of claims 12 to 16.

18. A computer program product, wherein when the computer program product is executed by a processor, the method according to any one of claims 12 to 16 is implemented.

19. A battery information collector, comprising the battery module detection system (300) according to any one of claims 1 to 11.

20. A power supply device, comprising a battery module, a battery management system, and the battery module detection system (300) according to any one of claims 1 to 11 or the battery information collector according to claim 19;
wherein the battery module detection system is configured to detect an insulation abnormality inside the battery module, generate a detection result on the basis of the insulation abnormality inside the battery module, and send the detection result to the battery management system;
wherein the battery management system is configured to output an abnormality prompt or a normal prompt on the basis of the detection result.

21. The power supply device according to claim 20, wherein the battery module comprises at least two cells connected in series.

22. An electric device, comprising the power supply device according to claim 20 or claim 21.
